# EUROPEAN PATENT APPLICATION

(11) **EP 4 061 009 A1**
(43) Date of publication of application: **21.09.2022**
(21) Application number: 20886639.2
(22) Date of filing: 21.10.2020
(51) Int. Cl.: H04R 17/00, H01L 41/047, H01L 41/09, H01L 41/18

(54) **PIEZOELECTRIC ELEMENT**

(30) Priority: 12.11.2019 JP 2019204626
(71) Applicant: FUJIFILM Corporation, Tokyo 106-8620 (JP)
(72) Inventor: KAGAWA, Yusuke, Minamiashigara-shi, Kanagawa 250-0193 (JP); HIRAGUCHI, Kazuo, Minamiashigara-shi, Kanagawa 250-0193 (JP)
(74) Representative: Klunker IP Patentanwälte PartG mbB
(86) International application number: PCT/JP2020/039534
(87) International publication number: WO 2021/095461

(57) **Abstract**

Provided is a piezoelectric element, of which thickness can be thin and uniform, and in which winding failure hardly occurs during manufacturing and deformation of the thin film electrode is unlikely to occur.

A piezoelectric element includes a piezoelectric layer, electrode layers formed on both sides of the piezoelectric layer, and a protective layer laminated on a surface of the electrode layer opposite to a surface on the piezoelectric layer side, in which the electrode layer has an exposed portion where the piezoelectric layer is not formed at least at a part of an end portion, and the piezoelectric layer has a gradually decreasing portion of which thickness gradually decreases toward the exposed portion in the end portion adjacent to the exposed portion.

## Description

### BACKGROUND OF THE INVENTION

### 1. Field of the Invention

The present invention relates to a piezoelectric element.

### 2. Description of the Related Art

With reduction in thickness of displays such as liquid crystal displays or organic EL displays, speakers used in these thin displays are also required to be lighter and thinner. In addition, in flexible displays having flexibility, speakers are also required to have flexibility in order to be integrated with flexible displays without impairing lightness and flexibility. It is considered to adopt a sheet-like piezoelectric element (electroacoustic conversion film) having properties of stretching and contracting in response to an applied voltage, for such a light and thin speaker having flexibility.

As such a sheet-like piezoelectric element having flexibility, a piezoelectric element having an electrode layer and a protective layer on both sides of a piezoelectric layer is suggested.

For example, WO2016/181965A discloses an electroacoustic conversion film including a piezoelectric layer having a dielectric property, two thin film electrodes formed on both sides of the piezoelectric layer, and two protective layers formed on surfaces of the two thin film electrodes, and further including a region in which the piezoelectric layer, the two thin film electrodes, and the two protective layers are adhered with one another in the same shape, and a region in which the piezoelectric layer, the two thin film electrodes, and the two protective layers overlap one another in a laminated direction and the piezoelectric layer and the two thin film electrodes are adhered with each other.

In WO2016/181965, in a case where a composition to be a piezoelectric layer is applied onto the thin film electrode, a region to which the composition is not applied is provided to form a non-adhered portion not adhered to the piezoelectric layer on the thin film electrode. It is disclosed that this non-adhered portion is used as an electrode drawer portion and is connected to a wire.

### SUMMARY OF THE INVENTION

As described above, the sheet-like piezoelectric element is required to be thin in order to be used in a flexible display or the like.

However, in a piezoelectric element having an electrode drawer portion as disclosed in WO2016/181965, a conductive foil extending the electrode drawer portion is connected to the electrode drawer portion, and an insulating sheet and the like is attached thereto in order to prevent the thin film electrode of the electrode drawer portion from being brought into contact with the other thin film electrode. Therefore, there is a problem that a thickness in the vicinity of the electrode drawer portion becomes thick. In addition, since a portion in the vicinity of the electrode drawer portion becomes thicker than the other region and the thickness becomes non-uniform, there is a concern that it becomes difficult to adhere the piezoelectric element in a case of laminating the piezoelectric element on another article.

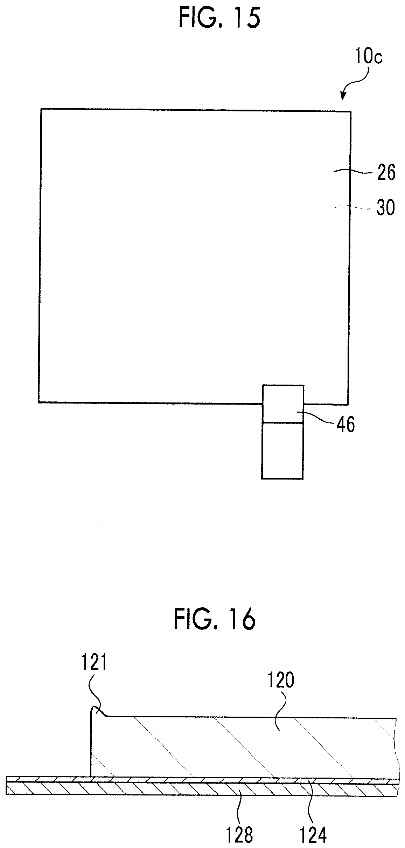

In addition, in WO2016/181965, in a case where the composition to be a piezoelectric layer is applied onto the thin film electrode, a region to which the composition is not applied is provided so that a non-adhered portion which is not adhered to the piezoelectric layer is formed on the thin film electrode, but at this time, the composition is required to be increased in viscosity to some extent in order for the applied composition to maintain a predetermined layered state. However, in a case where the viscosity of the composition is too high, an edge portion 121 of a composition layer (piezoelectric layer) 120 may be in a bulged state as illustrated in Fig. 16.

In general, the sheet-like piezoelectric element is desired to be manufactured by so-called roll-to-roll (hereinafter, also referred to as RtoR) from the viewpoint of manufacturing efficiency and the like. As is well known, RtoR is a manufacturing method of sending out a long sheet-like material from a roll on which a long sheet-like material is wound, continuously performing various processing while transporting the sheet-like material, and winding the sheet-like material after processing on the roll.

However, as described above, in a case where the edge portion 121 of the composition layer (piezoelectric layer) 120 is in a bulged state, bulges of the edge portion 121 are piled up in a case where the sheet-like material after applying the composition layer 120, and there is a concern that a difference in thickness from other regions become large, and winding failure occurs.

In addition, in a case where the edge portion 121 of the composition layer (piezoelectric layer) 120 is bulged, there is a concern that a thin film electrode is deformed in a case where a laminate of the thin film electrode and the protective layer is laminated on an upper portion.

An object of the present invention is to solve a problem of such a related art, and to provide a piezoelectric element, of which thickness can be thin and uniform, and in which winding failure hardly occurs during manufacturing and deformation of the thin film electrode is unlikely to occur.

In order to achieve the above-described object, the present invention has the following configurations.
[1] A piezoelectric element including a piezoelectric layer, electrode layers formed on both sides of the piezoelectric layer, and a protective layer laminated on a surface of the electrode layer opposite to a surface on a piezoelectric layer side,
   in which the electrode layer has an exposed portion where the piezoelectric layer is not formed at least at a part of an end portion, and
   the piezoelectric layer has a gradually decreasing portion of which a thickness gradually decreases toward the exposed portion in an end portion adjacent to the exposed portion.
[2] The piezoelectric element as described in [1], in which a width of the gradually decreasing portion in a direction in which thickness gradually decreases toward the exposed portion is 0.01 mm to 2 mm.
[3] The piezoelectric element as described in [1] or [2], further including an insulating member that covers at least a part of the electrode layer of the exposed portion.
[4] The piezoelectric element as described in [3], in which the insulating member covers the gradually decreasing portion of the piezoelectric layer.
[5] The piezoelectric element as described in any one of [1] to [4], in which the exposed portion protrudes outward in a projecting shape in a surface direction of the electrode layer.
[6] The piezoelectric element as described in any one of [1] to [5], further including a conductive sheet connected to the electrode layer of the exposed portion.
[7] The piezoelectric element as described in any one of [1] to [6], in which the piezoelectric layer is made of a polymer composite piezoelectric body containing piezoelectric particles in a matrix containing a polymer material.

According to the present invention, there is provided a piezoelectric element in which the thickness of the piezoelectric element, of which thickness can be thin and uniform, and in which winding failure hardly occurs during manufacturing, and deformation of the thin film electrode is unlikely to occur.

### BRIEF DESCRIPTION OF THE DRAWINGS

Fig. 1 is a cross-sectional view schematically illustrating an example of a piezoelectric element of the present invention.
Fig. 2 is a cross-sectional view taken along line A-A of the piezoelectric element of Fig. 1.
Fig. 3 is a view illustrating a partially enlarged portion of a cross-section taken along line B-B of a piezoelectric layer of Fig. 1.
Fig. 4 is a cross-sectional view schematically illustrating an example of the piezoelectric element of the present invention.
Fig. 5 is a cross-sectional view schematically illustrating an example of the piezoelectric element of the present invention.
Fig. 6 is a cross-sectional view schematically illustrating an example of the piezoelectric element of the present invention.
Fig. 7 is a cross-sectional view schematically illustrating an example of the piezoelectric element of the present invention.
Fig. 8 is a conceptual view for describing an example of a method of preparing a piezoelectric element.
Fig. 9 is a conceptual view for describing an example of a method of preparing a piezoelectric element.
Fig. 10 is a conceptual view for describing an example of a method of preparing a piezoelectric element.
Fig. 11 is a conceptual view for describing an example of a method of preparing a piezoelectric element.
Fig. 12 is a conceptual view for describing an example of a method of preparing a piezoelectric element.
Fig. 13 is a conceptual view for describing an example of a method of preparing a piezoelectric element.
Fig. 14 is a conceptual view for describing an example of a method of preparing a piezoelectric element.
Fig. 15 is a conceptual view for describing an example of a method of preparing a piezoelectric element.
Fig. 16 is a conceptual view for describing an example of a piezoelectric layer formed by application.

### DESCRIPTION OF THE PREFERRED EMBODIMENTS

Hereinafter, a piezoelectric element of an embodiment of the present invention will be described in detail based on suitable examples illustrated in the accompanying drawings.

Descriptions of the constituent requirements described below may be made based on representative embodiments of the present invention, but the present invention is not limited to such embodiments.

In the present specification, a numerical range expressed using "to" means a range including numerical values described before and after "to" as a lower limit and an upper limit.

### [Piezoelectric element]

A piezoelectric element of the embodiment of the present invention is
a piezoelectric element including a piezoelectric layer, electrode layers formed on both sides of the piezoelectric layer, and a protective layer laminated on a surface of the electrode layer opposite to a surface on the piezoelectric layer side,
in which the electrode layer has an exposed portion where the piezoelectric layer is not formed at least at a part of an end portion, and
the piezoelectric layer has a gradually decreasing portion of which thickness gradually decreases toward the exposed portion in the end portion adjacent to the exposed portion.

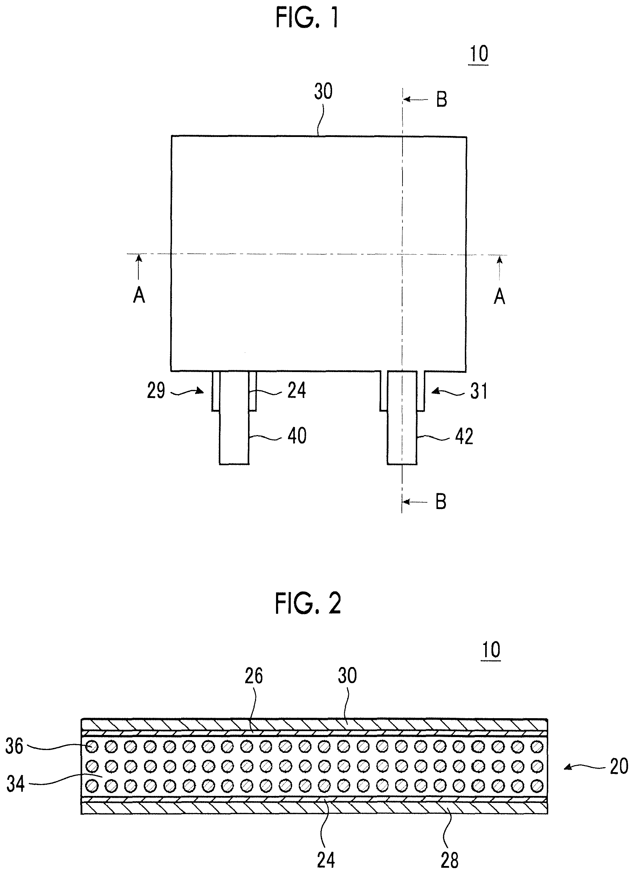

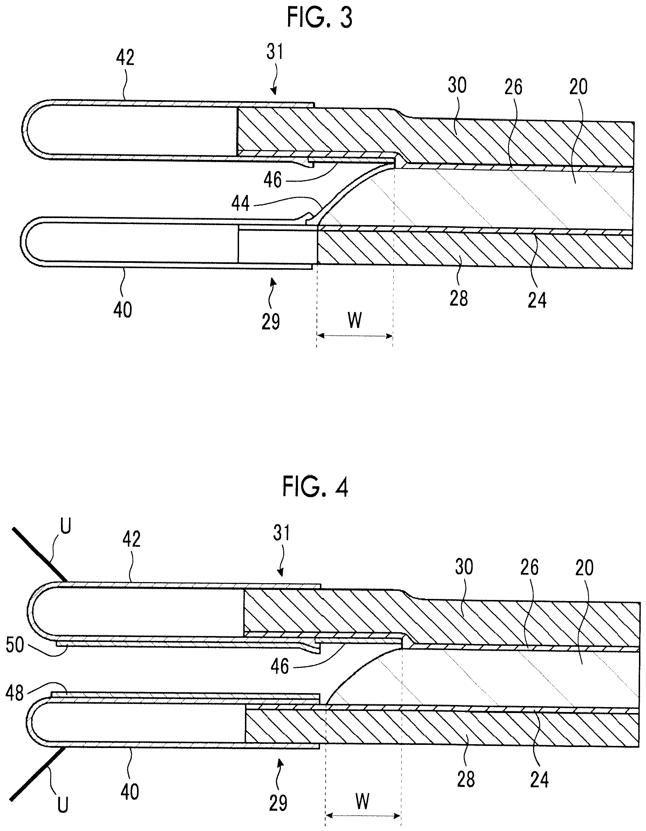

Fig. 1 illustrates a plan view schematically illustrating an example of a piezoelectric element of the embodiment of the present invention. Fig. 2 illustrates a sectional view taken along line A-A of the piezoelectric element of Fig. 1. Fig. 3 illustrates a partially enlarged view of a cross-sectional view taken along line B-B of the piezoelectric element of Fig. 1.

The piezoelectric element 10 as illustrated in Figs. 1 to 3 includes a piezoelectric layer 20 which is a sheet-like material having piezoelectric properties, a lower electrode 24 laminated on one surface of the piezoelectric layer 20, a lower protective layer 28 laminated on the lower electrode 24, an upper electrode 26 laminated on the other surface of the piezoelectric layer 20, an upper protective layer 30 laminated on the upper electrode 26, a conductive sheet 40, a conductive sheet 42, an insulating member 44, and an insulating member 46.

In the illustrated example, the piezoelectric layer 20 contains piezoelectric particles 36 in a matrix 34 containing a polymer material (refer to Fig. 2). In Fig. 3, the matrix 34 and the piezoelectric particles 36 in the piezoelectric layer 20 are not illustrated. In addition, the lower electrode 24 and the upper electrode 26 are electrode layers in the present invention. In addition, the lower protective layer 28 and the upper protective layer 30 are protective layers in the present invention.

As will be described later, the piezoelectric element 10 (piezoelectric layer 20) is polarized in a thickness direction as a preferable aspect.

As illustrated in Fig. 1, in the piezoelectric element 10, the lower electrode 24 and the lower protective layer 28 have a lower drawer portion 29 protruding in a convex shape outward (downward, in Fig. 1) in a surface direction, on an end portion on a left lower side in Fig. 1. In addition, in the piezoelectric element 10, the upper electrode 26 and the upper protective layer 30 have an upper drawer portion 31 protruding in a convex shape outward (downward, in Fig. 1) in the surface direction, on an end portion on a right lower side in Fig. 1.

The piezoelectric layers 20 are not formed on the electrode layers of the lower drawer portion 29 and the upper drawer portion 31, respectively, and the electrode layer is exposed. The lower drawer portion 29 and the upper drawer portion 31 are exposed portions in the present invention.

As illustrated in Fig. 3, the piezoelectric layer 20 has a region (region of a width indicated by W, in Fig. 3) in which a thickness is gradually decreased toward the exposed portion in the exposed portion, that is, the end portion adjacent to the lower drawer portion 29 and the upper drawer portion 31. Hereinafter, the region is referred to as a gradually decreasing portion.

In the example illustrated in Fig. 3, in the piezoelectric layer 20, a width of a surface adjacent to the lower electrode 24 is larger than a width of a surface adjacent to the upper electrode 26 in a direction in which a thickness gradually decreases, and an end surface can be inclined.

In the example illustrated in Fig. 3, the gradually decreasing portion has a shape that is curved outward in a convex shape, viewed in a cross-section in a direction in which the thickness gradually decreases, but the shape is not limited thereto, and may be a linear shape, or may be a shape that is curved in a concave shape.

In addition, in the examples illustrated in Figs. 1 and 3, a thickness of the piezoelectric layer 20 gradually decreases (having a gradually decreasing portion) outward in an entire region of an end edge side (lower edge side in Fig. 1) having the lower drawer portion 29 and the upper drawer portion 31. In addition, on an edge side facing the end edge (edge side on an upper side in Fig. 1), the piezoelectric layer 20 may have a gradually decreasing portion, or may not have a gradually decreasing portion.

In addition, in the illustrated example, on an edge side adjacent to an end edge having the lower drawer portion 29 and the upper drawer portion 31 (both end edge sides in a left-right direction of Fig. 1), as illustrated in Fig. 2, the piezoelectric layer 20 does not have a gradually decreasing portion. That is, in the left-right direction of Fig. 1, a width of a surface in contact with the lower electrode 24 is substantially the same as a width of a surface in contact with the upper electrode 26.

In the examples illustrated in Figs. 1 and 3, as a suitable aspect, the conductive sheet 40 is laminated on the lower electrode 24 of the lower drawer portion 29. In addition, as a preferable aspect, the conductive sheet 40 is provided so as to be folded back in a protruding direction of the lower drawer portion 29 and to interpose the lower electrode 24 and the lower protective layer 28. Similarly, a conductive sheet 42 is laminated on the upper electrode 26 of the upper drawer portion 31. In addition, as a preferable aspect, the conductive sheet 42 is provided so as to be folded back in a protruding direction of the upper drawer portion 31 and to interpose the upper electrode 26 and the upper protective layer 30.

The conductive sheets 40 and 42 are sheet-like materials formed of a metal material having conductivity such as copper foil, for example. In addition, the conductive sheets 40 and 42 may have a bonding layer having conductivity, and may be adhered to the lower drawer portion 29 and the upper drawer portion 31 via the bonding layer. Copper, aluminum, gold, silver, and the like are suitably exemplified as the material of the conductive sheets 40 and 42.

In addition, in the examples illustrated in Figs. 1 and 3, as a suitable aspect, the insulating member 44 is laminated on a part of the lower electrode 24 of the lower drawer portion 29, and the insulating member 46 is laminated on a part of the upper electrode 26 of the upper drawer portion 31. In the illustrated example, as a preferable aspect, the insulating member 44 is provided so as to cover the gradually decreasing portion of the piezoelectric layer 20 from the region adjacent to the piezoelectric layer 20 (gradually decreasing portion) of the lower electrode 24 of the lower drawer portion 29. The insulating member 44 includes the entire region of the lower drawer portion 29 in a direction orthogonal to a protrusion of the lower drawer portion 29 in the surface direction (the left-right direction of Fig. 1, hereinafter, also referred to as a width direction). In addition, in the illustrated example, as a preferable aspect, the insulating member 46 is provided so as to cover the upper electrode 26 from a region adjacent to the gradually decreasing portion of the upper electrode 26 of the upper drawer portion 31 to a position where the piezoelectric layer 20 and the upper electrode 26 are in contact with each other. The insulating member 46 includes the entire region of the upper drawer portion 31 in the direction orthogonal to the protrusion of the upper drawer portion 31 in the surface direction (the left-right direction of Fig. 1, hereinafter, also referred to as a width direction).

The insulating members 44 and 46 are sheet-like materials formed of a material having insulating properties such as a polyimide tape. Alternatively, the insulating members 44 and 46 may be an insulating layer formed by applying and curing a liquid insulating material. As the material of the insulating members 44 and 46, PI (polyimide), PET (polyethylene terephthalate), PEN (polyethylene naphthalate), PP (polypropylene), and the like are suitably exemplified.

By connecting to the lower electrode 24 of the lower drawer portion 29 and the upper electrode 26 of the upper drawer portion 31 and providing such conductive sheets 40 and 42, the electrodes are drawn from the lower electrode 24 and the upper electrode 26, both electrodes and the protective layer, which are thin films, are reinforced, and connection with a wire by soldering or the like can be facilitated. In addition, preferably, by folding back the conductive sheets 40 and 42 and interposing the electrode and the protective layer, the electrode and the protective layer are more suitably reinforced, and a surface for soldering for connecting the wire can also be selected.

In addition, by having the insulating member 44, in the configuration in which the lower electrode 24 is drawn by the lower drawer 29, even if the lower drawer portion 29 hangs down and comes into contact with an end surface of the piezoelectric element 10, the lower electrode 24 and the upper electrode 26 can be insulated. Similarly, in the configuration in which the upper electrode 26 is drawn by the upper drawer portion 31 by having the insulating member 46, even if the upper drawer portion 31 hangs down and comes into contact with an end surface of the piezoelectric element, the upper electrode 26 and the lower electrode 24 can be insulated. That is, by having such insulating members 44 and 46, it is possible to secure the insulating properties between the lower electrode 24 and the upper electrode 26 and to lead out the electrode layer as described above.

Here, as described above, the sheet-like piezoelectric element is required to be thin in order to be used in a flexible display or the like. However, in the piezoelectric element having an electrode drawer portion, as described above, to the electrode drawer portion, a conductive foil extending the electrode drawer portion is connected, or an insulating sheet to prevent the thin film electrode of the electrode drawer portion from coming into contact with the other thin film electrode is bonded. Therefore, there is a problem that a thickness in the vicinity of the electrode drawer portion becomes thick. In particular, the electrode drawer portion tends to be thick in a case of a configuration in which a part of the insulating sheet is interposed between the electrode layer and the piezoelectric layer. In addition, since a portion in the vicinity of the electrode drawer portion becomes thicker than the other regions and the thickness becomes non-uniform, there is a concern that it may be difficult to adhere the piezoelectric element in a case of laminating the piezoelectric element on other articles.

In addition, as will be described in detail later, the above-mentioned drawer portion (exposed portion) is formed by providing a region to which the composition is not applied in a case where the composition to be a piezoelectric layer is applied onto the electrode layer. At this time, in order for the applied composition to maintain a predetermined layer state, the composition needs to have a high viscosity to some extent. However, in a case where the viscosity of the composition is too high, the edge portion 121 of the composition layer (piezoelectric layer) 120 may be in a bulged state as illustrated in Fig. 16.

In general, the sheet-like piezoelectric element is desired to be manufactured by so-called roll-to-roll (hereinafter, also referred to as RtoR) from the viewpoint of manufacturing efficiency and the like. However, as described above, in a case where the edge portion 121 of the composition layer (piezoelectric layer) 120 is in a bulged state, the bulges of the edge portion 121 are piled up in a case where the sheet-like material after applying the composition layer 120 is wound up, and there is a concern that a difference in thickness from other regions becomes large, and winding failure occurs.

In addition, in a case where the edge portion 121 of the composition layer (piezoelectric layer) 120 is raised, there is a concern that the electrode layer is deformed in a case where a laminate (sheet-like material) of the upper electrode and the upper protective layer is laminated.

On the other hand, the piezoelectric element of the embodiment of the present invention has a gradually decreasing portion in which the thickness gradually decreases toward the exposed portion at an end portion adjacent to the exposed portion.

Since the piezoelectric element has the gradually decreasing portion, in a case where a conductive sheet and/or an insulating member is provided on a drawer portion (exposed portion), it is possible to arrange each member in a space between the electrode layer (upper electrode) and the piezoelectric layer of the gradually decreasing portion, and it is possible to suppress a thickness in the vicinity of the drawer portion from being larger than a thickness of the other region.

In addition, since it is possible to suppress a portion in the vicinity of the drawer portion from becoming thicker than the other region, it is possible to facilitate the adhesion in a case where the piezoelectric element is laminated on other articles.

In addition, as will be described in detail later, during manufacturing of a piezoelectric element by RtoR, in a case of applying the composition to be a piezoelectric layer on the electrode layer, by applying thereof such that a gradually decreasing portion is formed, there is no bulge on the edge portion in a case where a laminate after application is wound, and thus it is possible to suppress the occurrence of winding failure. In addition, since there is no bulge on the edge portion of the composition layer (piezoelectric layer), in a case where a laminate (sheet-like material) of the upper electrode and the upper protective layer is laminated, it is possible to suppress the upper electrode from being deformed.

Here, a width of the gradually decreasing portion in a direction in which the thickness gradually decreases toward the exposed portion is preferably 0.1 mm to 0.8 mm, and more preferably 0.2 mm to 0.5 mm. With this, each member is easily arranged in a space between the electrode layer (upper electrode) and the piezoelectric layer of the gradually decreasing portion, and it is possible to suitably suppress a thickness in the vicinity of the drawer portion from being larger than that of the other regions.

In addition, a width (a direction orthogonal to a protrusion direction of lower drawer portion 29 in a surface direction, left-right direction of Fig. 1) of the lower drawer portion 29 and the upper drawer portion 31 and a length (a direction orthogonal to a width direction) may appropriately set a size at which the electrodes can be drawn and the conductivity with the outside can be secured during mounting the piezoelectric element 10.

In addition, as shapes of the lower drawer portion 29 and the upper drawer portion 31, various shapes in which the electrode can be drawn can be used in addition to the rectangular shape in the illustrated example.

In addition, in the example illustrated in Fig. 1, the lower drawer portion 29 and the upper drawer portion 31 are arranged so that the positions in the surface direction do not overlap with each other as a preferable aspect. With this, it is possible to suppress the lower electrode 24 or the conductive sheet 40 of the lower drawer portion 29 from coming into contact with the upper electrode 26 or the conductive sheet 42 of the upper drawer portion 31 to cause a short circuit.

The lower drawer portion 29 and the upper drawer portion 31 may be arranged at positions where the positions in the surface direction overlap. In this case, as in the example illustrated in Fig. 4, it is preferable that an insulating member 48 that covers a surface of the lower drawer portion 29 on a lower electrode 24 side is arranged, and an insulating member 50 that covers a surface of the upper drawer portion 31 on an upper electrode 26 side is arranged. In the example illustrated in Fig. 4, since the conductive sheet 40 is arranged in the lower drawer portion 29, the insulating member 48 is arranged on a surface side of the conductive sheet 40 facing the upper electrode 26. Similarly, since the conductive sheet 42 is arranged in the upper drawer portion 31, the insulating member 50 is arranged on a surface side of the conductive sheet 42 facing the lower electrode 24.

With this, even in a case where the lower drawer portion 29 and the upper drawer portion 31 are arranged at positions where the positions in the surface direction overlap, it is possible to suppress the lower electrode 24 or the conductive sheet 40 of the lower drawer portion 29 from coming into contact with the upper electrode 26 or the conductive sheet 42 of the upper drawer portion 31 to cause a short-circuit.

As in the example of Fig. 4, in a case of a configuration in which a part of a surface of the conductive sheet is covered with the insulating member, a wire U may be connected to the surface other than the region covered with the insulating member.

In addition, in the example illustrated in Fig. 4, there is provided a configuration in which the insulating member 48 is arranged on a surface side of the conductive sheet 40 arranged in the lower drawer portion 29 facing the upper electrode 26, and the insulating member 50 is arranged on a surface side of the conductive sheet 42 arranged in the upper drawer portion 31 facing the lower electrode 24, but the configuration is not limited thereto, and it may be possible to suppress the lower electrode 24 or the conductive sheet 40 of the lower drawer portion 29 from coming into contact with the upper electrode 26 or the conductive sheet 42 of the upper drawer portion 31 to cause a short circuit.

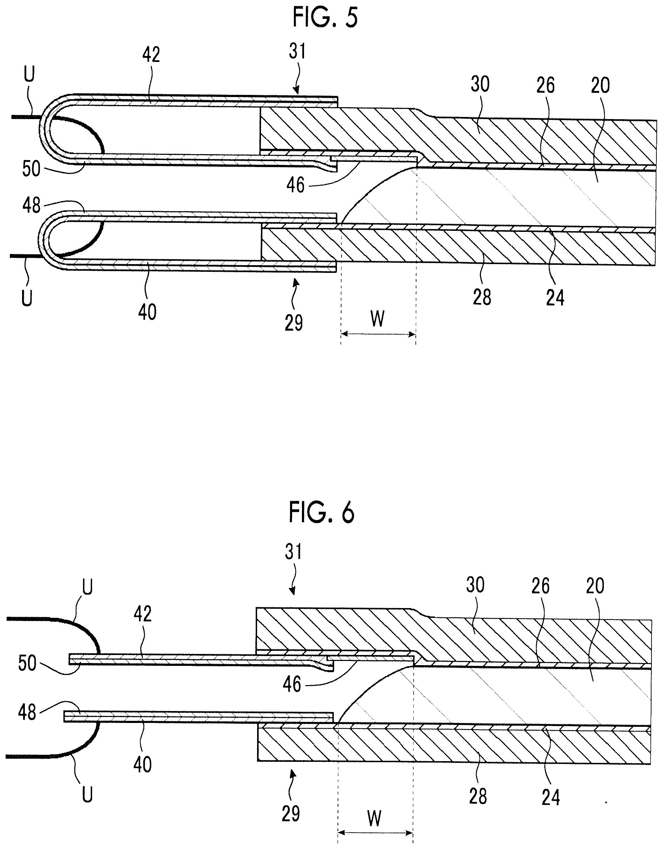

For example, as in the example illustrated in Fig. 5, the insulating member 48 may be arranged so as to cover the surface of the folded conductive sheet 40 facing the outside (the surface on a side opposite to a side of the lower drawer portion 29). Similarly, the insulating member 50 may be arranged so as to cover the surface of the folded conductive sheet 42 facing the outside (the surface on a side opposite to a side of the upper drawer portion 31).

In such a configuration, the wire U may be connected to an inner surface of the folded conductive sheet.

In addition, in the example illustrated in Fig. 1, there is provided a configuration in which the lower drawer portion 29 and the upper drawer portion 31 are provided on the same end edge (lower side edge in Fig. 1), but the configuration is not limited thereto, and there may be a configuration in which the lower drawer portion 29 and the upper drawer portion 31 are provided on different end edges. For example, there may be a configuration in which the lower drawer portion 29 is formed at the lower end edge in Fig. 1, and the upper drawer portion 31 is formed at an end edge facing the end edge, that is, at the upper end edge in Fig. 1.

In addition, the conductive sheets 40 and 42 can be used in various shapes in which the electrodes can be drawn, in addition to the rectangular shape in the illustrated example. That is, the size and the shape of the conductive sheets 40 and 42 may be appropriately set as a size and a shape at which the conductivity with the lower drawer portion 29 and the upper drawer portion 31 can be secured, and a wire can be connected during mounting, according to the size and the shape of the lower drawer portion 29 and the upper drawer portion 31.

For example, as in the example illustrated in Fig. 6, there may be a configuration in which the conductive sheets 40 and 42 are laminated so as to be electrically connected to the surface of the lower electrode 24 of the lower drawer portion 29 and the surface of the upper electrode 26 of the upper drawer portion 31 without folding back the conductive sheets 40 and 42.

As in the example illustrated in Fig. 6, in a case of the configuration in which the conductive sheets 40 and 42 are not folded back, the insulating member 48 is arranged on a surface side of the conductive sheet 40 arranged in the lower drawer portion 29 facing the upper electrode 26. In addition, the wire U is connected to the surface of the conductive sheet 40 opposite to the surface on which the insulating member 48 is arranged. Similarly, the insulating member 50 is arranged on a surface side of the conductive sheet 42 arranged in the upper drawer portion 31 facing the lower electrode 24. In addition, the wire U is connected to the surface of the conductive sheet 42 opposite to the surface on which the insulating member 50 is arranged.

In addition, in the illustrated example, there is a configuration in which the gradually decreasing portion is formed in the entire region of the piezoelectric layer 20 on an end edge having the lower drawer portion 29 and the upper drawer portion 31, but the configuration is not limited thereto, and there may be a configuration in which there is provided a gradually decreasing portion only in a region portion adjacent to the lower drawer portion 29 and the upper drawer portion 31.

In addition, there is provided a configuration in which the gradually decreasing portion is formed on an end edge side of the piezoelectric layer 20 having the lower drawer portion 29 and the upper drawer portion 31, but the configuration is not limited thereto, and the gradually decreasing portion may be formed on the other end edge side, or the gradually decreasing portion may be formed on the entire circumference of an end portion of the piezoelectric layer 20.

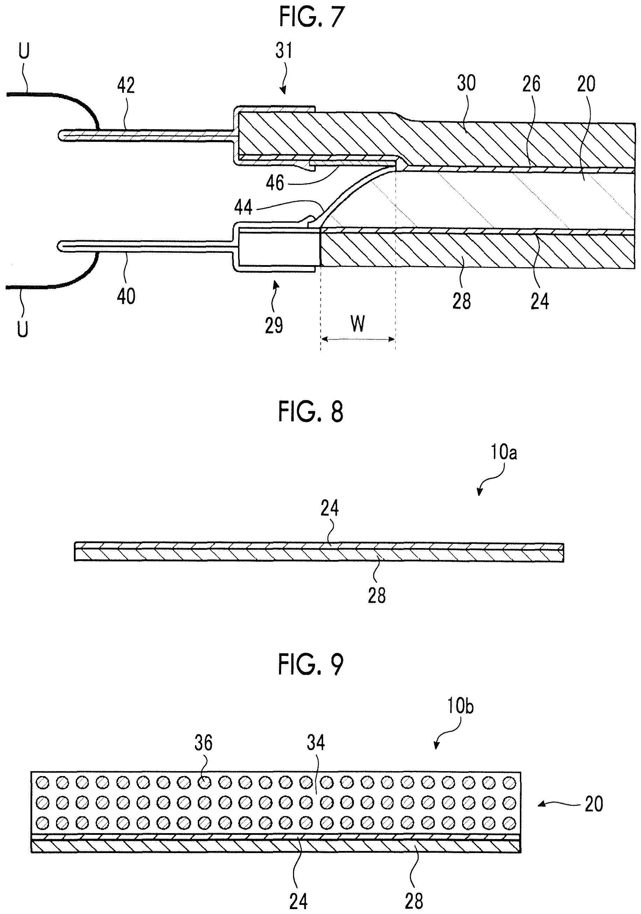

In addition, in the examples illustrated in Figs. 3 to 5, there is provided a configuration in which two sites interposing a folded portion, of the conductive sheet 40 arranged in the lower drawer portion 29 and the conductive sheet 42 arranged in the upper drawer portion 31, are separated from each other, but the configuration is not limited thereto. As in the example illustrated in Fig. 7, there may be also provided a configuration in which two sites interposing a folded portion, of the conductive sheet 40 arranged in the lower drawer portion 29 and the conductive sheet 42 arranged in the upper drawer portion 31, are in contact with each other. In addition, similar to the case of the configuration in which the insulating members 48 and 50 are laminated on the conductive sheets 40 and 42 as illustrated in Figs. 4 and 5, there may be a configuration in which two sites interposing the folded portion, of the conductive sheets 40 and 42, are in contact with each other.

As an example, such piezoelectric element 10 is used to generate (reproduce) sound due to vibration in response to an electrical signal, or convert vibration due to sound into an electrical signal in various audio devices (audio equipment) such as pickups used in musical instruments such as speakers, microphones, and guitars.

In addition, the piezoelectric element can also be used in pressure-sensitive sensors, power generation elements, and the like, in addition to these.

In addition, for example, in a case where the piezoelectric element 10 is used for a speaker, the piezoelectric element 10 may be used as the one that generates sound by the vibration of the film-shaped piezoelectric element 10 itself. Alternatively, the piezoelectric element 10 may be used as an exciter that is attached to a vibration plate, vibrates the vibration plate due to vibration of the piezoelectric element 10, and generates sound.

Hereinafter, each constituent element of the piezoelectric element of the embodiment of the present invention will be described in detail.

### [Piezoelectric layer]

The piezoelectric layer 20 may be a layer consisting of a known piezoelectric body. In the present invention, the piezoelectric layer 20 is preferably a polymer composite piezoelectric body containing piezoelectric particles 36 in a matrix 34 including a polymer material.

As the material of the matrix 34 (serving as a matrix and a binder) of the polymer composite piezoelectric body constituting the piezoelectric layer 20, a polymer material having viscoelasticity at room temperature is preferably used.

The piezoelectric element 10 of the embodiment of the present invention is suitably used for a speaker having flexibility such as a speaker for a flexible display. Here, it is preferable that the polymer composite piezoelectric body (piezoelectric layer 20) used for a speaker having flexibility satisfies the following requisites. Accordingly, it is preferable to use a polymer material having a viscoelasticity at room temperature as a material satisfying the following requirements.

Furthermore, in the present specification, the "room temperature" indicates a temperature range of approximately 0°C to 50°C.

### (i) Flexibility

For example, in a case of being gripped in a state of being loosely bent like a newspaper or a magazine as a portable device, the polymer composite piezoelectric body is continuously subjected to large bending deformation from the outside at a comparatively slow vibration of less than or equal to a few Hz. In this case, in a case where the polymer composite piezoelectric body is hard, large bending stress is generated to that extent, and a crack is generated at the interface between the matrix and the piezoelectric particles, possibly leading to breakage. Accordingly, the polymer composite piezoelectric body is required to have suitable flexibility. In addition, in a case where strain energy is diffused into the outside as heat, the stress is able to be relieved. Accordingly, the loss tangent of the polymer composite piezoelectric body is required to be suitably large.

### (ii) Acoustic Quality

A speaker vibrates the piezoelectric particles at a frequency of an audio band of 20 Hz to 20 kHz, and the vibration energy causes the entire polymer composite piezoelectric body (piezoelectric element) to vibrate integrally such that a sound is reproduced. Therefore, in order to increase a transmission efficiency of the vibration energy, the polymer composite piezoelectric body is required to have appropriate hardness. In addition, in a case where frequency properties of the speaker are smooth, an amount of change in acoustic quality in a case where the lowest resonance frequency is changed in association with a change in the curvature decreases. Therefore, the loss tangent of the polymer composite piezoelectric body is required to be suitably large.

As described above, a polymer composite piezoelectric body is required to be rigid with respect to a vibration of 20 Hz to 20 kHz, and be flexible with respect to a vibration of less than or equal to a few Hz. In addition, the loss tangent of the polymer composite piezoelectric body is required to be suitably large with respect to the vibration of all frequencies of less than or equal to 20 kHz.

In general, a polymer solid has a viscoelasticity relieving mechanism, and a molecular movement having a large scale is observed as a decrease (relief) in a storage elastic modulus (Young's modulus) or the local maximum (absorption) in a loss elastic modulus along with an increase in a temperature or a decrease in a frequency. Among them, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer composite piezoelectric body (the piezoelectric layer 20), the polymer material of which the glass transition point is room temperature, in other words, the polymer material having viscoelasticity at room temperature is used in the matrix, and thus the polymer composite piezoelectric body which is rigid with respect to a vibration of 20 Hz to 20 kHz and is flexible with respect to a vibration of less than or equal to a few Hz is realized. In particular, from a viewpoint of suitably exhibiting such behavior, it is preferable that a polymer material of which the glass transition temperature at a frequency of 1 Hz is room temperature, that is, 0°C to 50°C is used in the matrix of the polymer composite piezoelectric body.

As the polymer material having viscoelasticity at room temperature, various known materials are able to be used as long as the material has dielectric properties. Preferably, a polymer material of which the maximum value of a loss tangent at a frequency of 1 Hz at room temperature, that is, 0°C to 50°C in a dynamic viscoelasticity test is greater than or equal to 0.5 is used.

Accordingly, in a case where the polymer composite piezoelectric body is slowly bent due to an external force, stress concentration on the interface between the matrix and the piezoelectric particles at the maximum bending moment portion is relieved, and thus good flexibility is obtained.

In addition, it is preferable that, in the polymer material, a storage elastic modulus (E') at a frequency of 1 Hz according to dynamic viscoelasticity measurement is greater than or equal to 100 MPa at 0°C and is less than or equal to 10 MPa at 50°C.

Accordingly, it is possible to reduce a bending moment which is generated in a case where the polymer composite piezoelectric body is slowly bent due to the external force, and it is possible to make the polymer composite piezoelectric body rigid with respect to an acoustic vibration of 20 Hz to 20 kHz.

In addition, it is more suitable that the relative permittivity of the polymer material is greater than or equal to 10 at 25°C. Accordingly, in a case where a voltage is applied to the polymer composite piezoelectric body, a higher electric field is applied to the piezoelectric particles in the matrix, and thus a large deformation amount can be expected.

However, in consideration of securing good moisture resistance or the like, it is suitable that the relative permittivity of the polymer material is less than or equal to 10 at 25°C.

As the polymer material satisfying such conditions, cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, polybutyl methacrylate, and the like are exemplified. In addition, as these polymer materials, a commercially available product such as Hybrar 5127 (manufactured by Kuraray Co., Ltd.) is also able to be suitably used. Among them, as the polymer material, a material having a cyanoethyl group is preferably used, and cyanoethylated PVA is particularly preferably used.

Furthermore, only one of these polymer materials may be used, or a plurality of types thereof may be used in combination (mixture).

The matrix 34 using such a polymer material, as necessary, may use a plurality of polymer materials in combination.

That is, in order to control dielectric properties or mechanical properties, other dielectric polymer materials may be added to the matrix 34 in addition to the polymer material having viscoelasticity at room temperature, as necessary.

As the dielectric polymer material which is able to be added to the viscoelastic matrix, for example, a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, and a polyvinylidene fluoride-tetrafluoroethylene copolymer, a polymer having a cyano group or a cyanoethyl group such as a vinylidene cyanide-vinyl acetate copolymer, cyanoethyl cellulose, cyanoethyl hydroxy saccharose, cyanoethyl hydroxy cellulose, cyanoethyl hydroxy pullulan, cyanoethyl methacrylate, cyanoethyl acrylate, cyanoethyl hydroxy ethyl cellulose, cyanoethyl amylose, cyanoethyl hydroxy propyl cellulose, cyanoethyl dihydroxy propyl cellulose, cyanoethyl hydroxy propyl amylose, cyanoethyl polyacryl amide, cyanoethyl polyacrylate, cyanoethyl pullulan, cyanoethyl polyhydroxy methylene, cyanoethyl glycidol pullulan, cyanoethyl saccharose, and cyanoethyl sorbitol, and a synthetic rubber such as nitrile rubber or chloroprene rubber are exemplified.

Among them, a polymer material having a cyanoethyl group is suitably used.

Furthermore, the dielectric polymer material added to the matrix 34 of the piezoelectric layer 20 in addition to the polymer material having viscoelasticity at room temperature such as cyanoethylated PVA is not limited to one dielectric polymer, and a plurality of dielectric polymers may be added.

In addition, for the purpose of controlling the glass transition point, a thermoplastic resin such as a vinyl chloride resin, polyethylene, polystyrene, a methacrylic resin, polybutene, and isobutylene, and a thermosetting resin such as a phenol resin, a urea resin, a melamine resin, an alkyd resin, and mica may be added to the matrix 34 in addition to the dielectric polymer material.

Furthermore, for the purpose of improving adhesiveness, a viscosity imparting agent such as rosin ester, rosin, terpene, terpene phenol, and a petroleum resin may be added.

The amount of materials added to the matrix 34 of the piezoelectric layer 20 in a case where materials other than the polymer material having viscoelasticity such as cyanoethylated PVA is not particularly limited, and it is preferable that a ratio of the added materials to the matrix 34 is less than or equal to 30 mass%.

Accordingly, it is possible to exhibit properties of the polymer material to be added without impairing the viscoelasticity relieving mechanism of the matrix 34, and thus a preferable result is able to be obtained from a viewpoint of increasing a dielectric constant, of improving heat resistance, and of improving adhesiveness between the piezoelectric particles 36 and the electrode layer.

The piezoelectric layer 20 is a polymer composite piezoelectric body including the piezoelectric particles 36 in such a matrix 34.

The piezoelectric particles 36 consist of ceramics particles having a perovskite type or wurtzite type crystal structure.

As the ceramics particles forming the piezoelectric particles 36, for example, lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFe₃) are exemplified.

Only one of these piezoelectric particles 36 may be used, or a plurality of types thereof may be used in combination (mixture).

The particle diameter of the piezoelectric particles 36 is not limited, and may be appropriately selected depending on the size and the usage of the polymer composite piezoelectric body (piezoelectric element 10).

The particle diameter of the piezoelectric particles 36 is preferably 1 to 10 µm. By setting the particle diameter of the piezoelectric particles 36 to be in the range described above, a preferable result is able to be obtained from a viewpoint of allowing the polymer composite piezoelectric body (piezoelectric element 10) to achieve both high piezoelectric properties and flexibility.

In Fig. 2, the piezoelectric particles 36 in the piezoelectric layer 20 are uniformly dispersed in the matrix 34 with regularity, but the present invention is not limited thereto.

That is, in the matrix 34, the piezoelectric particles 36 in the piezoelectric layer 20 are preferably uniformly dispersed, and may also be irregularly dispersed.

In the piezoelectric layer 20 (polymer composite piezoelectric body), a quantitative ratio of the matrix 34 and the piezoelectric particles 36 in the piezoelectric layer 20 is not limited, and may be appropriately set according to the size in the surface direction or the thickness of the piezoelectric layer 20, the usage of the polymer composite piezoelectric body, properties required for the polymer composite piezoelectric body, and the like.

The volume fraction of the piezoelectric particles 36 in the piezoelectric layer 20 is set to preferably 30% to 80%, more preferably more than or equal to 50%, and therefore even more preferably 50% to 80%.

By setting the quantitative ratio of the matrix 34 and the piezoelectric particles 36 to be in the range described above, it is possible to obtain a preferable result from a viewpoint of achieving both high piezoelectric properties and flexibility.

The thickness of the piezoelectric layer 20 is not limited, and may be appropriately set according to the usage of the polymer composite piezoelectric body, properties required for the polymer composite piezoelectric body, and the like. The thicker the piezoelectric layer 20, the more advantageous it is in terms of rigidity such as the stiffness of a so-called sheet-like material, but the voltage (potential difference) required to stretch and contract the piezoelectric layer 20 by the same amount increases.

The thickness of the piezoelectric layer 20 is preferably 10 to 300 µm, more preferably 20 to 200 µm, and even more preferably 30 to 150 µm.

By setting the thickness of the piezoelectric layer 20 to be in the range described above, it is possible to obtain a preferable result from a viewpoint of compatibility between securing the rigidity and appropriate flexibility, or the like.

### [Electrode layer and protective layer]

As illustrated in Fig. 2, the piezoelectric element 10 of the illustrated example has a configuration in which the lower electrode 24 is provided on one surface of the piezoelectric layer 20, the lower protective layer 28 is provided on the surface thereof, the upper electrode 26 is provided on the other surface of the piezoelectric layer 20, and the upper protective layer 30 is provided on the surface thereof. Here, the upper electrode 26 and the lower electrode 24 form an electrode pair.

That is, the piezoelectric element 10 has a configuration in which both surfaces of the piezoelectric layer 20 are interposed between the electrode pair, that is, the upper electrode 26 and the lower electrode 24, and the laminate is interposed between the lower protective layer 28 and the upper protective layer 30.

As described above, in the piezoelectric element 10, the region interposed between the upper electrode 26 and the lower electrode 24 is stretched and contracted according to an applied voltage.

The lower protective layer 28 and the upper protective layer 30 have a function of covering the upper electrode 26 and the lower electrode 24 and applying appropriate rigidity and mechanical strength to the piezoelectric layer 20. That is, there may be a case where, in the piezoelectric element 10, the piezoelectric layer 20 consisting of the matrix 34 and the piezoelectric particles 36 exhibits extremely superior flexibility under bending deformation at a slow vibration but has insufficient rigidity or mechanical strength depending on the usage. As a compensation for this, the piezoelectric element 10 is provided with the lower protective layer 28 and the upper protective layer 30.

The lower protective layer 28 and the upper protective layer 30 are not limited, and may use various sheet-like materials. As an example, various resin films are suitably exemplified.

Among them, by the reason of excellent mechanical properties and heat resistance, a resin film consisting of polyethylene terephthalate (PET), polypropylene (PP), polystyrene (PS), polycarbonate (PC), polyphenylene sulfite (PPS), polymethyl methacrylate (PMMA), polyetherimide (PEI), polyimide (PI), polyethylene naphthalate (PEN), triacetylcellulose (TAC), or a cyclic olefin-based resin is suitably used.

There is also no limitation on the thicknesses of the lower protective layer 28 and the upper protective layer 30. In addition, the thicknesses of the lower protective layer 28 and the upper protective layer 30 may basically be identical to each other or different from each other.

Here, in a case where the rigidity of the lower protective layer 28 and the upper protective layer 30 is too high, not only is the stretching and contracting of the piezoelectric layer 20 constrained, but also the flexibility is impaired. Therefore, it is advantageous in a case where the thicknesses of the lower protective layer 28 and the upper protective layer 30 are smaller unless mechanical strength or good handleability as a sheet-like material is required.

The thickness of the lower protective layer 28 and the upper protective layer 30 is preferably 3 µm to 50 µm, more preferably 4 µm to 20 µm, and even more preferably 4 µm to 10 µm.

Here, in the piezoelectric element 10, in a case where the thickness of the lower protective layer 28 and the upper protective layer 30 is less than or equal to twice the thickness of the piezoelectric layer 20, it is possible to obtain a preferable result from a viewpoint of compatibility between securing the rigidity and appropriate flexibility, or the like.

For example, in a case where the thickness of the piezoelectric layer 20 is 50 µm and the lower protective layer 28 and the upper protective layer 30 consist of PET, the thickness of the lower protective layer 28 and the upper protective layer 30 is preferably less than or equal to 100 µm, more preferably less than or equal to 50 µm, and even more preferably less than or equal to 25 µm.

In the piezoelectric element 10, the lower electrode 24 is formed between the piezoelectric layer 20 and the lower protective layer 28, and the upper electrode 26 is formed between the piezoelectric layer 20 and the upper protective layer 30.

The lower electrode 24 and the upper electrode 26 are provided to apply a driving voltage to the piezoelectric layer 20.

In the present invention, a forming material of the lower electrode 24 and the upper electrode 26 is not limited, and various conductors are able to be used. Specifically, metals such as carbon, palladium, iron, tin, aluminum, nickel, platinum, gold, silver, copper, titanium, chromium, and molybdenum, alloys thereof, laminates and composites of these metals and alloys, indium-tin oxide, and the like are exemplified. Among them, copper, aluminum, gold, silver, platinum, and indium-tin oxide are suitably exemplified as the lower electrode 24 and the upper electrode 26.

In addition, a forming method of the lower electrode 24 and the upper electrode 26 is not limited, and various known methods such as a vapor-phase deposition method (a vacuum film forming method) such as vacuum vapor deposition or sputtering, film formation using plating, and a method of bonding a foil formed of the materials described above are able to be used.

Among them, in particular, by the reason that the flexibility of the piezoelectric element 10 is able to be secured, a thin film made of copper, aluminum, or the like formed by using the vacuum vapor deposition is suitably used as the lower electrode 24 and the upper electrode 26. Among them, in particular, the copper thin film formed by using the vacuum vapor deposition is suitably used.

There is no limitation on the thickness of the lower electrode 24 and the upper electrode 26. In addition, the thicknesses of the lower electrode 24 and the upper electrode 26 may basically be identical to each other or different from each other.

Here, similarly to the lower protective layer 28 and upper protective layer 30 mentioned above, in a case where the rigidity of the lower electrode 24 and the upper electrode 26 is too high, not only is the stretching and contracting of the piezoelectric layer 20 constrained, but also the flexibility is impaired. Therefore, it is advantageous in a case where the thicknesses of the lower electrode 24 and the upper electrode 26 are smaller as long as electrical resistance is not excessively high. That is, it is preferable that the lower electrode 24 and the upper electrode 26 are thin film electrodes. That is, it is preferable that the lower electrode 24 and the upper electrode 26 are thin film electrodes.

The thickness of the lower electrode 24 and the upper electrode 26 is thinner than that of the protective layer, is preferably 0.05 µm to 5 µm, more preferably 0.05 µm to 2 µm, and even more preferably 0.1 µm to 1 µm.

Here, in the piezoelectric element 10, in a case where the product of the thicknesses of the lower electrode 24 and the upper electrode 26 and the Young's modulus is less than the product of the thicknesses of the lower protective layer 28 and the upper protective layer 30 and the Young's modulus, the flexibility is not considerably impaired, which is suitable. For example, in a case of a combination consisting of the lower protective layer 28 and the upper protective layer 30 formed of PET (Young's modulus: approximately 6.2 GPa) and the lower electrode 24 and the upper electrode 26 formed of copper (Young's modulus: approximately 130 GPa), in a case where the thickness of the lower protective layer 28 and the upper protective layer 30 is 25 µm, the thickness of the lower electrode 24 and the upper electrode 26 is preferably less than or equal to 1.2 µm, more preferably less than or equal to 0.3 µm, and particularly preferably less than or equal to 0.1 µm.

In the piezoelectric element 10, it is preferable that the maximum value of the loss tangent (Tanδ) at a frequency of 1 Hz according to the dynamic viscoelasticity measurement exists at room temperature, and it is more preferable that a maximum value of greater than or equal to 0.1 exists at room temperature.

Accordingly, even in a case where the piezoelectric element 10 is subjected to large bending deformation from the outside at a comparatively slow vibration of less than or equal to a few Hz, it is possible to effectively diffuse the strain energy to the outside as heat, and thus it is possible to prevent a crack from being generated on the interface between the matrix and the piezoelectric particles.

In the piezoelectric element 10, it is preferable that the storage elastic modulus (E') at a frequency of 1 Hz according to the dynamic viscoelasticity measurement is 10 GPa to 30 GPa at 0°C, and 1 GPa to 10 GPa at 50°C. Regarding this condition, the same applies to the piezoelectric layer 20.

Accordingly, the piezoelectric element 10 is able to have large frequency dispersion in the storage elastic modulus (E'). That is, the piezoelectric element 10 is able to be rigid with respect to a vibration of 20 Hz to 20 kHz, and is able to be flexible with respect to a vibration of less than or equal to a few Hz.

In addition, in the piezoelectric element 10, it is preferable that the product of the thickness and the storage elastic modulus (E') at a frequency of 1 Hz according to the dynamic viscoelasticity measurement is 1.0 × 10⁵ to 2.0 × 10⁶ (1.0E + 05 to 2.0E + 06) N/m at 0°C, and 1.0 × 10⁵ to 1.0 × 10⁶ (1.0E + 05 to 1.0E + 06) N/m at 50°C. Regarding this condition, the same applies to the piezoelectric layer 20.

Accordingly, the piezoelectric element 10 is able to have appropriate rigidity and mechanical strength within a range not impairing the flexibility and the acoustic properties.

Furthermore, in the piezoelectric element 10, it is preferable that the loss tangent at a frequency of 1 kHz at 25°C is greater than or equal to 0.05 in a master curve obtained by the dynamic viscoelasticity measurement. Regarding this condition, the same applies to the piezoelectric layer 20.

Accordingly, the frequency properties of a speaker using the piezoelectric element 10 are smoothened, and thus it is also possible to decrease the changed amount of acoustic quality in a case where the lowest resonance frequency f₀ is changed according to a change in the curvature of the speaker.

In the present invention, the storage elastic modulus (Young's modulus) and the loss tangent of the piezoelectric element 10, the piezoelectric layer 20, and the like may be measured by a known method. As an example, the measurement may be performed using a dynamic viscoelasticity measuring device DMS6100 (manufactured by SII Nanotechnology Inc.).

Examples of the measurement conditions include a measurement frequency of 0.1 Hz to 20 Hz (0.1 Hz, 0.2 Hz, 0.5 Hz, 1 Hz, 2 Hz, 5 Hz, 10 Hz, and 20 Hz), a measurement temperature of -50°C to 150°C, a temperature rising rate of 2°C/min (in a nitrogen atmosphere), a sample size of 40 mm × 10 mm (including the clamped region), and a chuck-to-chuck distance of 20 mm

Next, an example of a manufacturing method of the piezoelectric element 10 will be described with reference to Figs. 8 to 15.

First, as illustrated in Fig. 8, a sheet-like material 10a is prepared in which the lower electrode 24 is formed on the lower protective layer 28. The sheet-like material 10a may be produced by forming a copper thin film or the like as the lower electrode 24 on the surface of the lower protective layer 28 using vacuum vapor deposition, sputtering, plating, or the like.

In a case where the lower protective layer 28 is extremely thin, and thus the handleability is degraded, a lower protective layer 28 with a separator (temporary support) may be used as necessary. As the separator, a PET film having a thickness of 25 µm to 100 µm, and the like are able to be used. The separator may be removed after thermal compression bonding of the upper electrode 26 and the upper protective layer 30 and before laminating any member on the lower protective layer 28.

On the other hand, a composition is prepared by dissolving a polymer material as a material of a matrix in an organic solvent, adding the piezoelectric particles 36 such as PZT particles thereto, and stirring and dispersing the resultant product.

The organic solvent is not limited, and various organic solvents are able to be used.

In a case where the sheet-like material 10a is prepared and the coating material is prepared, the coating material is cast (applied) onto the sheet-like material 10a, and the organic solvent is evaporated and dried. Accordingly, as illustrated in Fig. 9, a laminate lOb in which the lower electrode 24 is provided on the lower protective layer 28 and the piezoelectric layer 20 is formed on the lower electrode 24 is produced. The lower electrode 24 refers to an electrode on the base material side in a case where the piezoelectric layer 20 is applied, and does not indicate the vertical positional relationship in the laminate.

A casting method of the coating material is not particularly limited, and all known methods (coating devices) such as a slide coater or a doctor knife are able to be used.

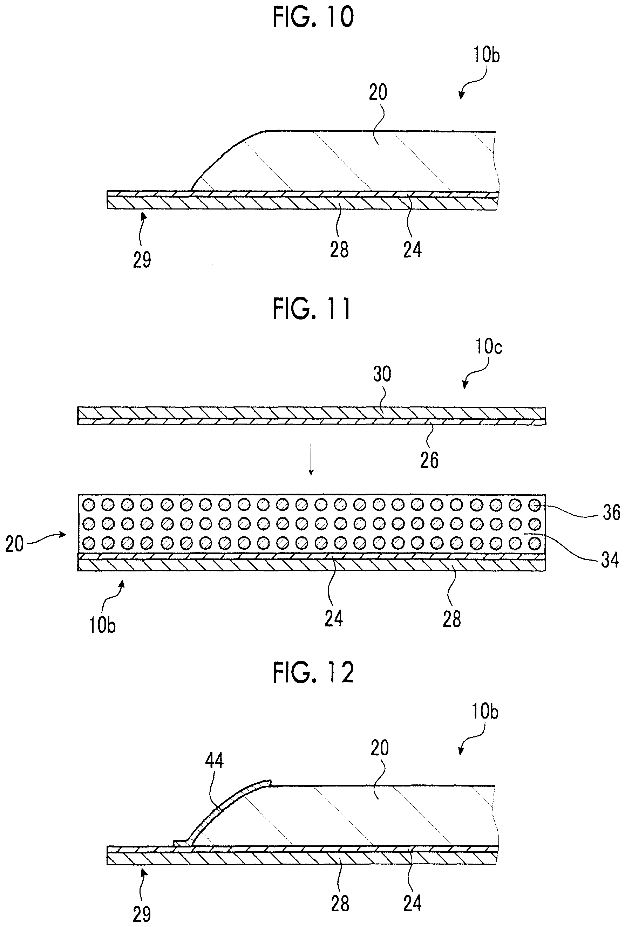

Here, as illustrated in Fig. 10, in a case of applying the composition to be the piezoelectric layer 20, a region where the composition is not applied is provided on at least one end edge side of the sheet-like material 10a. This region is a region that is an exposed portion (lower drawer portion). In addition, at an end portion of the piezoelectric layer 20 adjacent to this region, a gradually decreasing portion of which thickness gradually decreases toward the exposed portion is formed.

A method of applying the composition only to a part of the region on the lower electrode 24 side of the laminate 10b is not particularly limited, and for example, in a case of casting the composition with a slide coater, a width of a slit opening for discharging the composition may be adjusted to be smaller than a width of the lower electrode 24. Alternatively, the application may be performed by masking the region of the end portion that is an unapplied portion of the composition.

In addition, the gradually decreasing portion can be formed by adjusting the viscosity or the like of the composition to be applied.

As described above, in the piezoelectric element 10, in addition to the viscoelastic material such as cyanoethylated PVA, a dielectric polymer material may be added to the matrix 34.

In a case where the polymer material is added to the matrix 34, the polymer material added to the above-mentioned composition may be dissolved.

After the laminate 10b in which the lower electrode 24 is provided on the lower protective layer 28 and the piezoelectric layer 20 is formed on the lower electrode 24 is produced, the piezoelectric layer 20 is preferably subjected to polarization processing (poling).

A polarization processing method of the piezoelectric layer 20 is not limited, and a known method is able to be used.

Before the polarization processing, calender processing may be performed to smoothen the surface of the piezoelectric layer 20 using a heating roller or the like. By performing the calender processing, a thermal compression bonding process described below is able to be smoothly performed.

In this way, while the piezoelectric layer 20 of the laminate 10b is subjected to the polarization processing, a sheet-like material 10c is prepared in which the upper electrode 26 is formed on the upper protective layer 30. This sheet-like material 10c may be produced by forming a copper thin film or the like as the upper electrode 26 on the surface of the upper protective layer 30 using vacuum vapor deposition, sputtering, plating, or the like.

Next, as illustrated in Fig. 11, the sheet-like material 10c is laminated on the laminate 10b in which the piezoelectric layer 20 is subjected to the polarization processing while the upper electrode 26 faces the piezoelectric layer 20.

Furthermore, a laminate of the laminate 10b and the sheet-like material 10c is interposed between the upper protective layer 30 and the lower protective layer 28, and is subjected to the thermal compression bonding using a heating press device, a heating roller pair, or the like.

The sheet-like material 10c may have a size and a shape such that in a case of being laminated on the laminate 10b, a part thereof becomes an exposed portion that is not adhered to the piezoelectric layer 20.

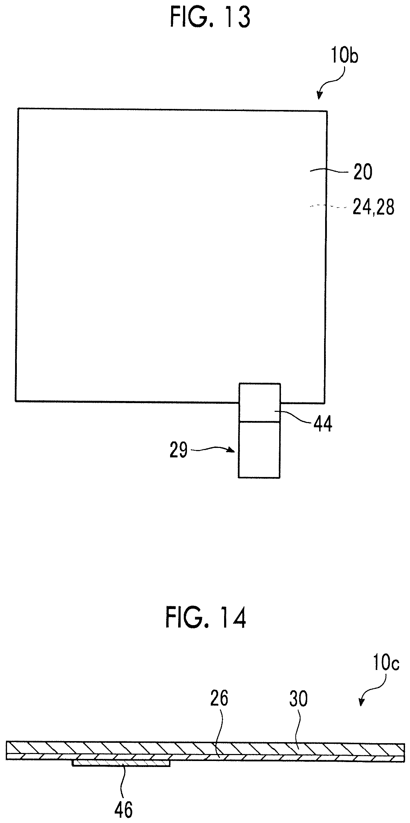

In addition, as a preferable aspect, in a case where the insulating members 44 and 46 are provided, the insulating member 44 is provided so as to cover a region in which the composition of the laminate 10b is not applied, that is, a part of the exposed portion and the gradually decreasing portion of the piezoelectric layer 20, as illustrated in Figs. 12 and 13 before the sheet-like material 10c is laminated on the laminate 10b. As described above, in a case where the insulating member 44 is a sheet-like material (insulating sheet), the insulating sheet may be attached to a part of the exposed portion and the gradually decreasing portion of the piezoelectric layer 20, and in a case where a liquid insulating material is used, the insulating material may be applied and cured to form the insulating member 44.

In addition, before the sheet-like material 10c is laminated on the laminate 10b, as illustrated in Figs. 14 and 15, the insulating member 46 is provided at a position corresponding to the exposed portion of the sheet-like material 10c and the gradually decreasing portion of the piezoelectric layer 20.

As described above, after insulating members are provided on the sheet-like material 10c and the laminate 10b, respectively, by laminating the sheet-like material 10c on the laminate 10b, it is possible to easily make a configuration of having the insulating members.

By the above steps, a piezoelectric element in which an electrode layer and a protective layer are laminated on both surfaces of the piezoelectric layer 20 is produced. The produced piezoelectric element may be cut into a desired shape according to various usages.

Here, by cutting at least a part of the exposed portion into a residual shape, a drawer portion having a desired shape can be formed.

Such a piezoelectric element may be produced using a cut sheet-like material, or may be produced by roll-to-roll (RtoR).

Here, as described above, in a case of forming by RtoR, in a case where the edge portion of the piezoelectric layer of the laminate 10b is in a bulged state (refer to Fig. 16), the bulges of the edge portion are piled up in a case where the laminate 10b is wound up, and there is a concern that a difference in thickness from other regions becomes large, and winding failure occurs.

In addition, in a case where the edge portion of the piezoelectric layer is bulged, there is a concern that the electrode layer (upper electrode) is deformed in a case where the sheet-like material 10c is laminated on the laminate 10b.

On the other hand, in the present invention, in a case where the composition to be the piezoelectric layer 20 is applied on the lower electrode 24 at a time of manufacturing the piezoelectric element by RtoR, by applying the composition such that a gradually decreasing portion is formed, there is no bulge at the edge portion in a case where the laminate 10b after application is wound, and thus it is possible to suppress the occurrence of winding failure. In addition, since the edge portion of the piezoelectric layer 20 does not have a bulge, it is possible to suppress the deformation of the upper electrode 26 in a case where the sheet-like material 10c is laminated.

Here, in a case where the composition is applied to the sheet-like material 10a by RtoR, a method of continuously applying the composition in a longitudinal direction while transporting the long sheet-like material 10a in the longitudinal direction is considered. In this case, a long piezoelectric layer is formed in the longitudinal direction of the long sheet-like material 10a. Therefore, it is preferable to form the exposed portion and the gradually decreasing portion in at least one end portion in a width direction (direction orthogonal to the longitudinal direction) of the long sheet-like material 10a.

In addition, in a case where the composition is applied to the sheet-like material 10a by RtoR, the composition is intermittently applied in the longitudinal direction while transporting the long sheet-like material 10a in the longitudinal direction, and a plurality of piezoelectric layers may be formed on the sheet-like material 10a. For example, in a case where a planar shape of each piezoelectric layer is substantially quadrangular, a gradually decreasing portion may be formed on each of the four end edge sides of each piezoelectric layer.

In a case where a voltage is applied to the lower electrode 24 and the upper electrode 26 of such a piezoelectric element 10, the piezoelectric particles 36 stretch and contract in the polarization direction according to the applied voltage. As a result, the piezoelectric element 10 (piezoelectric layer 20) contracts in the thickness direction. At the same time, the piezoelectric element 10 stretches and contracts in the in-plane direction due to the Poisson's ratio. The degree of stretching and contracting is about 0.01% to 0.1%. In the in-plane direction, those that stretch and contract isotropically in all directions are as described above.

As described above, the thickness of the piezoelectric layer 20 is preferably about 10 to 300 µm. Therefore, the degree of stretching and contracting in the thickness direction is as very small as about 0.3 µm at the maximum.

Contrary to this, the piezoelectric element 10, that is, the piezoelectric layer 20, has a size much larger than the thickness in the surface direction. Therefore, for example, in a case where the length of the piezoelectric element 10 is 20 cm, the piezoelectric element 10 stretches and contracts by a maximum of about 0.2 mm as a voltage is applied.

In addition, in a case where a pressure is applied to the piezoelectric element 10, electric power is generated by the action of the piezoelectric particles 36.

By using this, the piezoelectric element 10 can be used for various usages such as a speaker, a microphone, and a pressure-sensitive sensor, as described above.

Here, it is known that in a case where a general piezoelectric element consisting of a polymer material such as PVDF has in-plane anisotropy in the piezoelectric properties, and has anisotropy in the amount of stretching and contracting in the surface direction in a case where a voltage is applied.

Contrary to this, the piezoelectric layer consisting of a polymer composite piezoelectric body containing piezoelectric particles in a matrix including a polymer material has no in-plane anisotropy in the piezoelectric properties, and stretches and contracts isotropically in all directions in the surface direction.

According to the piezoelectric element 10 that stretches and contracts isotropically and two-dimensionally, compared to a case where a general piezoelectric element made of PVDF or the like that stretch and contract greatly in only one direction is laminated, the vibration can occur with a large force, and a louder and more beautiful sound can be generated.

In the example illustrated in Fig. 1, the configuration is such that one piezoelectric element 10 is provided, but the present invention is not limited to this, and a plurality of piezoelectric elements 10 of the embodiment of the present invention may be laminated. In addition, the piezoelectric element 10 of the embodiment of the present invention may have a long shape and may be folded back once or more, preferably a plurality of times in the longitudinal direction to form a stack of a plurality of layers of the piezoelectric element 10.

Hereinabove, while the piezoelectric element of the embodiment of the present invention have been described in detail, the present invention is not limited to the examples described above, and various improvements or modifications may be naturally performed within a range not deviating from the gist of the present invention.

The piezoelectric element can be suitably used for various usages such as audio equipment including speakers and microphones and pressure-sensitive sensors.

### Explanation of References

10: piezoelectric element
10a, 10c: sheet-like material
10b: laminate
20: piezoelectric layer
24: lower electrode
26: upper electrode
28: lower protective layer
29: lower drawer portion
30: upper protective layer
31: upper drawer portion
34: matrix
36: piezoelectric particles
40, 42: conductive sheet
44, 46, 48, 50: insulating member
W: width of gradually decreasing portion

## Claims

1. A piezoelectric element comprising:
a piezoelectric layer;
electrode layers formed on both sides of the piezoelectric layer; and
a protective layer laminated on a surface of the electrode layer opposite to a surface on a piezoelectric layer side,
wherein the electrode layer has an exposed portion where the piezoelectric layer is not formed at least at a part of an end portion, and
the piezoelectric layer has a gradually decreasing portion of which a thickness gradually decreases toward the exposed portion in an end portion adjacent to the exposed portion.

2. The piezoelectric element according to claim 1,
wherein a width of the gradually decreasing portion in a direction in which thickness gradually decreases toward the exposed portion is 0.01 mm to 2 mm.

3. The piezoelectric element according to claim 1 or 2, further comprising:
an insulating member that covers at least a part of the electrode layer of the exposed portion.

4. The piezoelectric element according to claim 3,
wherein the insulating member covers the gradually decreasing portion of the piezoelectric layer.

5. The piezoelectric element according to any one of claims 1 to 4,
wherein the exposed portion protrudes outward in a projecting shape in a surface direction of the electrode layer.

6. The piezoelectric element according to any one of claims 1 to 5, further comprising:
a conductive sheet connected to the electrode layer of the exposed portion.

7. The piezoelectric element according to any one of claims 1 to 6,
wherein the piezoelectric layer is made of a polymer composite piezoelectric body containing piezoelectric particles in a matrix containing a polymer material.
